# EUROPÄISCHE PATENTSCHRIFT

(11) **EP 0 680 846 B1**
(45) Veröffentlichungstag und Bekanntmachung des Hinweises auf die Patenterteilung: **11.06.1997**
(21) Anmeldenummer: 95104744.8
(22) Anmeldetag: 30.03.1995
(51) Int. Cl.: B60R 16/02

(54) **Elektronisches Steuergerät für Kraftfahrzeuge, insbesondere elektronisches Bremssteuergerät**
Electronic control device for vehicles, particularly electronic brake control device
Appareil électrique de commande pour véhicules, en particulier appareil électronique de commande de freins

(30) Priorität: 02.05.1994 DE 4415386
(43) Veröffentlichungstag der Anmeldung: 08.11.1995
(73) Patentinhaber: KNORR-BREMSE SYSTEME FÜR NUTZFAHRZEUGE GmbH, 80809 München (DE)
(72) Erfinder: Bielig, Peter, D-80836 München (DE); Brähler, Klaus, D-81927 München (DE); Gschossmann, Günther, D-84453 Mühldorf (DE)
(74) Vertreter: von Bülow, Tam, Dr.

(56) Entgegenhaltungen:
- EP-A- 0 025 913
- EP-A- 0 415 039
- EP-A- 0 426 103
- DE-A- 3 429 067
- DE-A- 3 920 805
- DE-A- 4 209 474

## Beschreibung

Die Erfindung bezieht sich auf ein elektronisches Steuergerät für Kraftfahrzeuge und insbesondere auf ein elektronisches Bremssteuergerät für Kraftfahrzeuge.

In Kfz-Verkabelungen kommt es häufig aufgrund schlechter Übergangswiderstände zu unerwünschten Potentialdifferenzen, speziell auf den Massepfaden. Hierdurch haben verschiedene im Kraftfahrzeug vorhandene elektrische Geräte ein unterschiedliches Spannungsniveau des Massepotentials. Beispielsweise kann ein Bremssteuergerät wie z.B. ein elektronisches Blockierschutzgerät, ein sonstiges elektronisches Bremssteuergerät etc. ein wesentlich höheres Massepotential haben als die von ihm angesteuerten, einseitig auf Masse liegenden Verbraucher wzb. Magnetventile. Dies kann zu Fehlfunktionen oder Schädigungen von elektronischen Bauteilen des Steuergerätes führen, da sie außerhalb ihrer Spezifikation betrieben werden.

Liegt das Massepotential des Verbrauchers höher als das Massepotential des Steuergerätes, so hat - vom Steuergerät aus gesehen - der Verbraucher einen höheren Widerstand, was für die Funktion des Steuergerätes nicht weiter kritisch ist. Im schlimmsten Fall arbeitet der Verbraucher nicht mehr richtig, beispielsweise schaltet ein Magnetventil trotz angelegter Erregerspannung nicht mehr durch. Liegt dagegen das Massepotential des Verbrauchers niedriger als das des Steuergerätes, so erscheint das Massepotential des Verbrauchers aus Sicht des Steuergerätes als negative Spannung in Bezug auf das Massepotential des Steuergerätes. Dies kann zu Überlastungen des Steuergerätes führen und zur Zerstörung von einigen Bauteilen darin.

Zur Lösung dieser Probleme ist es bisher nur möglich, eine eigene Masseleitung durch das Fahrzeug zu schleifen, was einen erheblichen Mehraufwand bei der Verkabelung darstellt, jedoch die Möglichkeit von Potentialdifferenzen aufgrund von Übergangswiderständen an Steckverbindungen nicht ausschließt.

Aufgabe der Erfindung ist es, ein elektronisches Steuergerät für Kraftfahrzeuge mit einer einfachen und kostengünstigen Schaltungsanordnung in die Lage zu versetzen, mit den in Kraftfahrzeugsteuergeräten üblicherweise ausschließlich vorhandenen positiven Versorgungsspannungen die beschriebene Potentialdifferenz zwischen dem Massepotential des Steuergerätes und dem Massepotential eines Verbrauchers zu erkennen und daraufhin zum Schutz gefährdeter Bauteile geeignete Maßnahmen zu ergreifen.

Diese Aufgabe wird durch die im Anspruch 1 angegebenen Merkmale gelöst. Vorteilhafte Ausgestaltungen und Weiterbildungen sind den Unteransprüchen zu entnehmen.

Das Grundprinzip der Lösung nach der Erfindung besteht darin, einen Prüfstrom durch den Verbraucher fließen zu lassen und dann Gegenmaßnahmen zu ergreifen, wenn dieser Prüfstrom außerhalb vorgegebener Grenzwerte liegt. Diese Gegenmaßnahmen können darin bestehen, einen Leistungsschalter, über den der Verbraucher mit elektrischer Energie versorgt wird, abzuschalten, wenn aufgrund zu hoher Massepotentialdifferenzen eine Gefahr für Bauteile des Steuergerätes vorhanden ist. In vielen Fällen ist der von dem Steuergerät angesteuerte Verbraucher ein Magnetventil, das mit Spannungsimpulsen angesteuert wird, weshalb die Steuergeräte hierfür einen Leistungsschalter verwenden, der beispielsweise ein Transistor sein kann. Diese Leistungsschalter sind empfindlich auf zu hohe Strombelastungen, weshalb es nach einer Weiterbildung der Erfindung vorteilhaft ist, diesen Leistungsschalter von der Auswerteschaltung abzuschalten, wenn Gegenmaßnahmen ergriffen werden müssen.

Nach einer besonders bevorzugten Weiterbildung der Erfindung ist vorgesehen, daß die Schaltungsanordnung den Prüfstrom mit einer vorgegebenen Mindestgröße nur dann durch den Verbraucher fließen läßt, wenn das Massepotential des Steuergerätes um einen vorgegebenen Betrag größer ist als das Massepotential des Verbrauchers. Somit fließt der Prüfstrom nicht ständig sondern erst ab Erreichen einer vorgegebenen Massepotentialdifferenz. Die für den Prüfstrom verantwortliche Schaltungsanordnung aktiviert sich sozusagen selbst, wenn diese vorgegebene Potentialdifferenz erreicht ist. Nach Anspruch 4 wird dies im wesentlichen durch eine Zenerdiode erreicht. Nach den Ansprüchen 9 und 10 durch einen Optokoppler, dessen Schalttransistor nur dann durchschaltet, wenn der durch die lichtemittierende Diode des Optokopplers fließende Strom eine vorgegebene Ansprechschwelle für den Schalttransistor erreicht hat. Beim Anspruch 5 wird dieses Merkmal durch die Diode erreicht, die ebenfalls erst ab Erreichen einer Schwellenspannung stromdurchlässig wird.

Im folgenden wird die Erfindung anhand von Ausführungsbeispielen im Zusammenhang mit der Zeichnung ausführlicher erläutert. Es zeigt:
- Fig. 1: Ein Prinzipschaltbild eines Steuergerätes nach einem ersten Ausführungsbeispiel der Erfindung;
- Fig. 2: ein Prinzipschaltbild eines Steuergerätes nach einem zweiten Ausführungsbeispiel der Erfindung;
- Fig. 3: ein Prinzipschaltbild eines Steuergerätes nach einem dritten Ausführungsbeispiel der Erfindung.

Gleiche Bezugszeichen in den einzelnen Figuren bezeichnen gleiche bzw. einander entsprechende Teile.

Ein elektronisches Steuergerät 1 für Kraftfahrzeuge hat drei verschiedene Anschlüsse, nämlich einen ersten Anschluß 2 zur Verbindung mit positiver Versorgungsspannung Ub, einen Anschluß 3 zur Verbindung mit Gerätemasse M1 und einen dritten Anschluß 4 zur Verbindung mit einem Verbraucher 5. Der Verbraucher 5 ist seinerseits mit dem Massepotential M2 verbunden, das im folgenden als Verbrauchermasse bezeichnet wird. Aufgrund schlechter Übergangswiderstände kann es vorkommen, daß zwischen den Massepotentialen M1 und M2 eine Potentialdifferenz auftritt. Das Steuergerät 1 enthält üblicherweise einen Spannungsregler 6 und ein Steuerorgan 7, das beispielsweise ein Blockierschutzregler, ein Antriebsschlupfregler, eine elektronische Bremssteuerung etc. sein kann. Dieses Steuerorgan 7 wird vom Spannungsregler 6 mit geregelter Betriebsspannung versorgt. Der Ausgang dieses Steuerorgans 7 steuert einen Leistungsschalter 8, der den Verbraucher 5 mit Versorgungsspannung Ub verbindet.

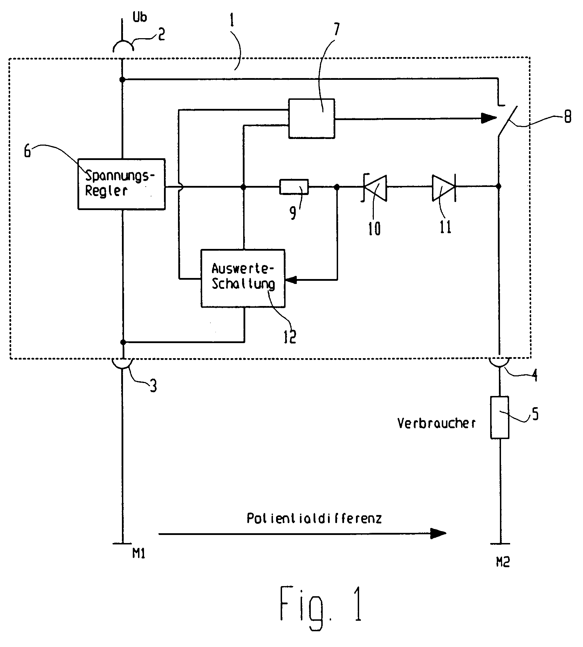

Im Ausführungsbeispiel der Fig. 1 wird jetzt nach der Erfindung vom Spannungsregler 6 über eine Reihenschaltung aus einem Widerstand 9, einer Zenerdiode 10 und einer Diode 11 ein Prüfstrom über den Anschluß 4 und den Verbraucher 5 zur Verbrauchermasse M2 geschickt. Der durch diesen Prüfstrom am Widerstand 9 entstehende Spannungsabfall wird von einer Auswerteschaltung 12 gemessen und mit vorgegebenen Schwellwerten verglichen. Diese Auswerteschaltung 12 kann beispielsweise einen Komparator aufweisen, der den am Widerstand 9 gemessenen spannungsabfall mit einem oder mehreren Bezugswerten vergleicht.

Der Prüfstrom und damit die Höhe des Spannungsabfalles am Widerstand 9 sind abhängig von der Potentialdifferenz zwischen den beiden Massepotentialen M1 und M2. Bei sehr großer Potentialdifferenz in Pfeilrichtung ist auch der Spannungsabfall am Widerstand 9 entsprechend groß, so daß die Auswerteschaltung bei Erreichen eines vorgegebenen Schwellwertes Gegenmaßnahmen einleiten kann, die hier darin bestehen, den Leistungsschalter 8 zu öffnen und so den Verbraucher 5 abzuschalten, so daß primär der empfindliche Leistungsschalter 8 vor zu hoher Strombelastung und damit vor Beschädigungen geschützt wird. Dieser Leistungsschalter ist in vielen Fällen integrierter Bestandteil des Steuerorgans 7, so daß in diesen Fällen dann auch das Steuerorgan 7 vor Beschädigungen geschützt wird.

Die Zenerdiode 10 kann mit ihrer Durchbruchsspannung so ausgewählt werden, daß sie erst ab einer vorgegebenen Spannungsdifferenz leitend wird, so daß der Prüfstrom erst ab Überschreiten dieser Spannungsdifferenz fließt. Die in Richtung vom Spannungsregler 6 zum Verbraucher 5 in Durchlaßrichtung geschaltete Diode 11 verhindert, daß bei geschlossenem Leistungsschalter 8 die Auswerteschaltung mit der Betriebsspannung Ub beaufschlagt wird.

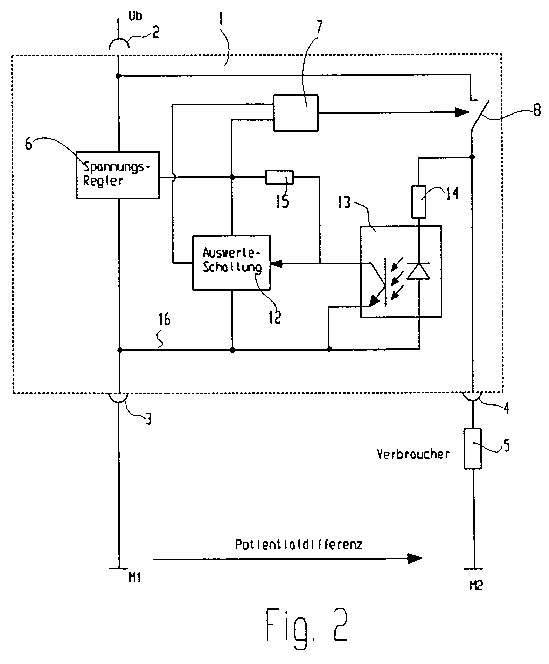

Das Ausführungsbeispiel der Fig. 2 unterscheidet sich durch den Aufbau der Schaltung für den Prüfstrom, während das Steuergerät 1 gleich aufgebaut ist. Der Masseanschluß des Steuergerätes 1, der das Massepotential M1 führt, ist über einen Optokoppler 13 mit dem Ausgang des Steuergerätes 1 und damit dem Anschluß 4 des Verbrauchers 5 verbunden. Zusätzlich liegt in diesem Zweig noch ein Widerstand 14. Ist das Potential M1 größer als das Potential M2, so fließt ein Strom von der Gerätemasse M1 über den Anschluß 3, eine Leitung 16 durch die lichtimittierende Diode des Optokopplers 13, den Widerstand 14, den Anschluß 4 und den Verbraucher 5 zur Verbrauchermasse M2. Überschreitet dieser Strom den vorgegebenen Grenzwert, so schaltet der Transistor des Optokopplers 13 durch und verbindet einen Widerstand 15 über die Leitung 16 und den Anschluß 3 mit dem Massepotential M1. Der andere Anschluß des Widerstandes 15 ist mit einem Ausgang des Spannungsreglers 6 verbunden. Durch den Widerstand 15 fließt dann ein elektrischer Strom, der einen Spannungsabfall an ihm hervorruft, der wiederum von der Auswerteschaltung 12 erfaßt werden kann. Die Auswerteschaltung 12 kann dann direkt den Schalter 8 öffnen oder an das Steuerorgan 7 ein entsprechendes Signal liefern, das das Steuergerät 7 veranlaßt, den Schalter 8 zu öffnen. Bei diesem Ausführungspiel der Fig. 2 fließt also der Prüfstrom von der Gerätemasse M1 zur Verbrauchermasse M2 und nicht - wie bei Fig. 1 - vom Spannungsregler zur Verbrauchermasse.

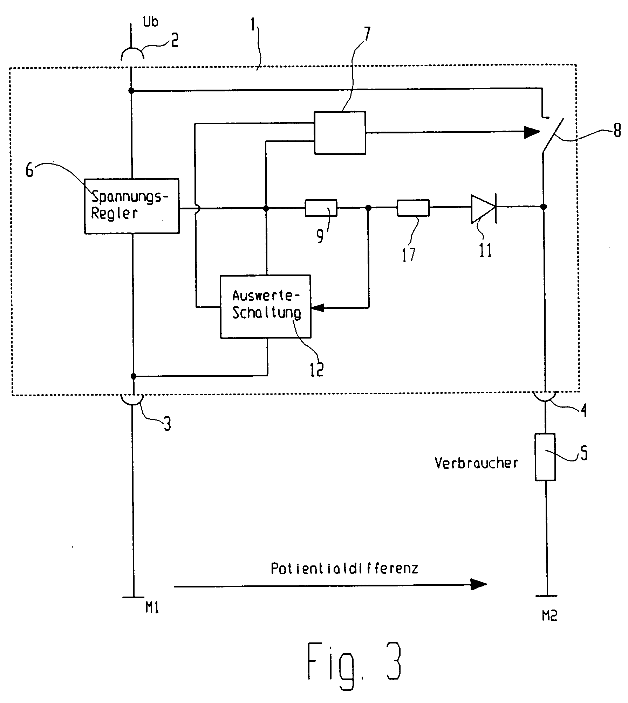

Das Ausführungsbeispiel der Fig. 3 entspricht im wesentlichen dem der Fig. 1 und unterscheidet sich von diesem lediglich darin, daß die Zenerdiode 10 der Fig. 1 durch einen Widerstand 17 ersetzt ist. Die Widerstände 9 und 17 wirken zusammen mit dem Verbraucher als Spannungsteiler, wobei aber auch hier - wie im Beispiel der Fig. 1 - der Spannungsabfall am Widerstand 9 erfaßt wird. Der Prüfstrom fließt in diesem Ausführungsbeispiel schon bei kleinerer Potentialdifferenz zwischen M1 und M2, sobald die sehr geringe Ansprechspannung der Diode 11 überschritten ist, während er im Ausführungsbeispiel der Fig. 1 erst dann fließt, wenn die Potentialdifferenz zwischen M1 und M2 die Zenerspannung der Zenerdiode 10 überschritten hat.

## Patentansprüche

1. Elektronisches Steuergerät für Kraftfahrzeuge, insbesondere elektronisches Bremssteuergerät, mit mindestens einem Anschluß (2) für Versorgungsspannung, mindestens einem Masseanschluß (3, M1) und mindestens einem Ausgangsanschluß (4) zur Ansteuerung eines einseitig auf Masse (M2) liegenden elektrischen Verbrauchers (5), gekennzeichnet
durch eine Schaltungsanordnung (9-17), die einen Prüfstrom durch den Verbraucher (5) fließen läßt, und
durch ein Meßorgan (9), das die Größe dieses Prüfstromes erfaßt und einer Auswerteschaltung (12) zuführt, die in Abhängigkeit von der Größe des Prüfstromes Gegenmaßnahmen zum Schutz von Beschädigungen von Bauteilen des Steuergerätes (1) ergreift.

2. Elektronisches Steuergerät nach Anspruch 1, dadurch gekennzeichnet, daß die Auswerteschaltung (12) direkt oder über ein Steuerorgan (7) einen Leistungsschalter (8) ansteuert, der die Energieversorgung des Verbrauchers (5) abschaltet.

3. Steuergerät nach Anspruch 1 oder 2, dadurch gekennzeichnet, daß die Schaltungsordnung (9-17) den Prüfstrom mit einer vorgegebenen Mindestgröße nur dann durch den Verbraucher fließen läßt, wenn das Massepotential (M1) des Steuergerätes (1) um einen vorgegebenen Betrag größer ist als das Massepotential (M2) des Verbrauchers (5).

4. Steuergerät nach Anspruch 3, dadurch gekennzeichnet, daß der Prüfstrom von einer Versorgungsspannung (6) über einen Widerstand (9), eine Zenerdiode (10) und den Verbraucher (5) zum Massepotential (M2) des Verbrauchers (5) fließt.

5. Steuergerät nach Anspruch 4, dadurch gekennzeichnet, daß im Strompfad des Prüfstromes eine von der Versorgungsspannung (6) zum Verbraucher (5) in Durchlaßrichtung geschaltete Diode (11) vorgesehen ist.

6. Steuergerät nach den Ansprüchen 1, 2 oder 3, dadurch gekennzeichnet, daß der Prüfstrom aus einer Versorgungsspannung (6) über einen ersten Widerstand (9), einen zweiten Widerstand (17), eine in Durchlaßrichtung geschaltete Diode (11) und den Verbraucher (5) zum Massepotential (M2) des Verbrauchers (5) fließt.

7. Steuergerät nach einem der Ansprüche 1 bis 6, dadurch gekennzeichnet, daß die Größe des Prüfstromes gemessen und einer Auswerteschaltung (12) zugeführt wird, die erkennt, ob eine Potentialdifferenz zwischen dem Massepotential (M1) des Steuergerätes (1) und dem Massepotential (M2) des Verbrauchers (5) vorhanden ist.

8. Steuergerät nach Anspruch 7, dadurch gekennzeichnet, daß die Größe des Prüfstromes durch Messen des Spannungsabfalles an einem im Prüfstromkreis liegenden Widerstandes (9) erfaßt wird.

9. Steuergerät nach einem der Ansprüche 1 bis 3, dadurch gekennzeichnet, daß der Prüfstrom vom Massepotential (M1) des Steuergerätes (1) über eine Sendediode eines Optokopples (13) und den Verbraucher (5) zum Massepotential (M2) des Verbrauchers fließt.

10. Steuergerät nach Anspruch 9, dadurch gekennzeichnet, daß ein Schalttransistor dem Optokopplers (13) mit einem Anschluß mit der Auswerteschaltung (12) und gleichzeitig über einen Widerstand (15) mit Versorgungsspannung (6) verbunden ist und mit seinem anderen Anschluß über eine Leitung (16) mit dem Massepotential (M1) des Steuergerätes (1) verbunden ist und daß das durch den Prüfstrom hervorgerufene Schalten dieses Transistors von der Auswerteschaltung erfaßt und zur Erkennung einer Potentialdifferenz zwischen dem Massepotential (M1) des Steuergerätes (1) und dem Massepotential (M2) des Verbrauchers (5) ausgewertet wird.

## Claims

1. An electronic control apparatus for motor vehicles, in particular electronic brake control apparatus, comprising at least one supply voltage terminal (2), at least one ground terminal (3, M1) and at least one output terminal (4) for driving an electric load (5) having one connection to ground potential (M2),
**characterized by**
a circuit arrangement (9-17) for causing a test current to flow through the load (5) and
by a measuring element (9) for detecting the magnitude of this test current and feeding it to an evaluation circuit (12), which in response to the magnitude of the test current initiates counter measures to protect circuit elements of said control apparatus (1).

2. Electronic control apparatus according to claims 1,
**characterized in that**
said evaluation circuit (12) is controlling directly or via a control means (7), a power switch (8), which disconnects the load (5) from the energy supply.

3. Control apparatus according to claim 1 or 2,
**characterized in that**
the circuit arrangement (9-17) causes the test current having a minimum magnitude to flow trough the load (5) only if the ground potential (M1) of the control apparatus (1) exceeds the ground potential (M2) of the load (5) by a predetermined value.

4. Control apparatus according to claim 3,
**characterized in that**
the test current is flowing from a supply voltage (6) via a resistor (9), a Zener diode (10), and the load (5) to the ground potential (M2) of the load (5).

5. Control apparatus according to claim 4,
**characterized in that**
their is provided a diode (11) within the current path in the direction of the test current from the voltage supply (6) to the load (5).

6. Control apparatus according to claims 1, 2 or 3
**characterized in that**
the test current is flowing from a voltage supply (6) via a first resistor (9), a second resistor (17), an in forward direction connected diode (11) and the load (5) to the ground potential (M2) of the load (5).

7. Control apparatus according to one of claim 1 to 6,
**characterized in that**
the magnitude of the test current is measured and is fed to an evaluation circuit (12), which is determining whether a potential difference between the ground potential (M1) of the control apparatus (1) and the ground potential (M2) of the load (5) is present.

8. Control apparatus according to claim 7,
**charaterized in that,**
the magnitude of the current is detected by measuring the voltage drop on a resistor (9), which lies within the test current path.

9. Control apparatus according to one of claim 1 to 3,
**characterized in that,**
the test current is flowing from the ground potential (M1) of the control apparatus (1) via a transmitter diode of an optocoupler (13) and the load (5) to the ground potential (M2) of the load.

10. Control apparatus according to claim 9,
**characterized in that**
a switching transistor of the optocoupler (13) is connected with one terminal of the evaluation circuit (12) and simultaneously via a resistor (15) with the voltage supply (6), and with its other terminal via a lead (16) with the ground potential (M1) of the control apparatus (1), and
in that the switching of said transistor caused by the test current is detected by the evaluation circuit and is evaluated for detecting of a potential difference between the ground potential (M1) of the control apparatus (1) and the ground potential (M2) of the load.

## Revendications

1. Appareil électronique de commande pour véhicule, en particulier appareil électronique de commande de freins, avec au moins une connexion (2) pour la tension d'alimentation, au moins une connexion de masse (3, M1) et au moins une connexion de sortie (4) pour l'excitation d'un récepteur (5) électrique relié d'un côté à la masse (M2), caractérisé par un montage de circuit (9-17) qui fait passer un courant de contrôle à travers le récepteur (5), et
par un élément de mesure (9) qui enregistre l'ampleur de ce courant de contrôle et le dirige vers une commutation d'évaluation (12) qui produit, en fonction de l'amplitude du courant de contrôle, des réactions pour protéger les composants de l'appareil de commande (1) contre toute dégradation.

2. Appareil de commande électronique selon la revendication 1, caractérisé en ce que la commutation d'évaluation (12) excite directement, ou par un élément de commande (7), un commutateur de puissance (8) qui coupe l'alimentation en énergie du récepteur (5).

3. Appareil de commande selon la revendication 1 ou 2, caractérisé en ce que la structure de circuit (9-17) n'autorise le courant de contrôle à traverser le récepteur avec une ampleur minimale donnée que si le potentiel de masse (M1) de l'appareil de commande (1) dépasse le potentiel de masse (M2) du récepteur (5) d'une valeur donnée.

4. Appareil de commande selon la revendication 3, caractérisé en ce que le courant de contrôle s'écoule depuis une tension d'alimentation (6) en passant par une résistance (9), une diode Zener (10) et le récepteur (5) vers le potentiel de masse (M2) du récepteur (5).

5. Appareil de commande selon la revendication 4, caractérisé en ce qu'une diode (11) connectée dans le sens passant depuis la tension d'alimentation (6) vers le récepteur (5) est prévue dans le trajet du courant de contrôle.

6. Appareil de commande selon les revendications 1, 2 ou 3, caractérisé en ce que le courant de contrôle s'écoule depuis une tension d'alimentation (6) en passant par une première résistance (9), une deuxième résistance (17), une diode (11) connectée dans le sens passant et le récepteur (5) vers le potentiel de masse (M2) du récepteur (5).

7. Appareil de commande selon l'une des revendications 1 à 6, caractérisé en ce que l'ampleur du courant de contrôle est mesurée et transmise à une commutation d'évaluation (12), qui détecte s'il existe une différence de potentiel entre le potentiel de masse (M1) de l'appareil de commande (1) et le potentiel de masse (M2) du récepteur (5).

8. Appareil de contrôle selon la revendication 7, caractérisé en ce que l'ampleur du courant de contrôle est enregistrée par la mesure de la chute de tension sur une résistance (9) située dans le circuit du courant de contrôle.

9. Appareil de commande selon l'une des revendications 1 à 3, caractérisé en ce que le courant de contrôle s'écoule depuis le potentiel de masse (M1) de l'appareil de commande (1) en passant par une diode émettrice d'un coupleur optoélectronique (13) et le récepteur (5) vers le potentiel de masse (M2) du récepteur.

10. Appareil de commande selon la revendication 9, caractérisé en ce qu'un transistor de commutation du coupleur optoélectronique (13) est relié selon une connexion à la commutation d'évaluation (12) et en même temps, par l'intermédiaire d'une résistance (15), à la tension d'alimentation (6), et est relié selon son autre connexion par une ligne (16) au potentiel de masse (M1) de l'appareil de commande (1), de sorte que la commutation de ce transistor provoquée par le courant de contrôle est enregistrée par la commutation d'évaluation pour détecter s'il y a une différence de potentiel entre le potentiel de masse (M1) de l'appareil de commande (1) et le potentiel de masse (M2) du récepteur (5).
